# EUROPEAN PATENT SPECIFICATION

(11) **EP 4 061 102 B1**
(45) Date of publication and mention of the grant of the patent: **28.01.2026**
(21) Application number: 20886649.1
(22) Date of filing: 10.11.2020
(51) Int. Cl.: H05K 3/34, H05B 6/74, H05B 6/80, H05K 1/18, B23K 1/00, B23K 1/005, B23K 1/19, B23K 101/42, B23K 103/16, H05B 6/64, H05K 1/11, H05K 3/24

(54) **MOUNTING WIRING BOARD, METHOD OF MOUNTING ELECTRONIC COMPONENT, AND MOUNTING WIRING BOARD HAVING AN ELECTRONIC DEVICE ATTACHED THEREON**
MONTAGE-VERDRAHTUNGSPLATINE, VERFAHREN ZUR MONTAGE ELEKTRONISCHER BAUTEILE UND MONTAGE-VERDRAHTUNGSPLATINE MIT DARAUF BEFESTIGTER ELEKTRONISCHER VORRICHTUNG
CARTE DE CÂBLAGE DE MONTAGE, PROCÉDÉ DE MONTAGE D'UN COMPOSANT ÉLECTRONIQUE ET CARTE DE CÂBLAGE DE MONTAGE SUR LAQUELLE EST FIXÉ UN DISPOSITIF ÉLECTRONIQUE

(30) Priority: 15.11.2019 JP 2019206988
(43) Date of publication of application: 21.09.2022
(73) Proprietor: National Institute of Advanced Industrial Science and Technology, Chiyoda-ku Tokyo 100-8921 (JP)
(72) Inventor: KANAZAWA, Kenji, Tsukuba-shi, Ibaraki 305-8560 (JP); UEMURA, Sei, Tsukuba-shi, Ibaraki 305-8560 (JP); NISHIOKA, Masateru, Sendai-shi, Miyagi 983-8551 (JP); NAKAMURA, Takashi, Sendai-shi, Miyagi 983-8551 (JP)
(74) Representative: Forstmeyer, Dietmar
(86) International application number: PCT/JP2020/041903
(87) International publication number: WO 2021/095723

(56) References cited:
- WO-A1-2005/101932
- DE-A1- 10 316 513
- GB-A- 2 376 201
- JP-A- 2000 183 513
- JP-A- 2001 044 616
- JP-A- 2019 136 771
- JP-A- 2019 136 771
- US-A1- 2003 121 958

## Description

### FIELD OF THE INVENTION

The present invention relates to a mounting wiring board, a mounting wiring board having an electronic device attached thereon, and a method of mounting an electronic device.

### BACKGROUND OF THE INVENTION

As a method for heating solder when mounting an electronic device, the use of a microwave has been known. The microwave is included in one of the heating methods because the microwave is an internal heating method and can perform heating in a short time. However, actually, a spark occurs in some cases when a conductive material is irradiated with a microwave. The present inventors developed microwave apparatus that enables heating while preventing a spark, and found that an electronic device was able to be mounted to a low heat resistant substrate with solder without causing a spark.

There has been also proposed a mounting process using induction heating (IH). For example, Patent Literature 1 discloses that an electrode and a mounting component are selectively joined with solder. Specifically, a mounting region is surrounded by a coil, and a ferrite material is disposed at a position opposed to the coil, thereby generating a magnetic flux around the coil. The generated magnetic flux travels through the ferrite to be focused, and an induction heating limited to the mounting region is performed, thus enabling selectively joining the electrode and the mounting component with solder by the heating.

Under the background that microwave mounting of a micro-sized electronic device is difficult, the present inventors found that by heating a heat generation pattern in a predetermined shape disposed on a support by microwave irradiation, solder on a base disposed on the support was able to be heated corresponding to the heat generation pattern. This enabled a solder melting process and soldering and mounting of micro-sized electronic device. In the heat generation pattern, the temperature increases in a short time due to a magnetic loss caused by an action of a magnetic field generated by the microwave irradiation and/or due to an induced current excited in metal particles by the action of the magnetic field. A heat conduction occurs from the heat generation pattern with the increased temperature to the solder on a conductive pattern printed on the base, and this heat conduction enables selectively and efficiently melting the solder in a short time, thus resulting in allowing mounting the micro-sized electronic device without a damage.

As described above, since microwave irradiation directly heats an object to be heated, the object can be heated in a short time and there is an advantage of reducing unevenness of temperature due to heat conduction. In addition, there are advantages that the object can be heated in a non-contact manner and only those with good microwave absorption can be selectively heated.

Relating to the efficient heating technique using the microwave, the use of ferrite that absorbs an electromagnetic wave, such as a microwave, to generate heat has been reported. Patent Literature 2 discloses that a Y-type hexagonal crystal ferrite having a specific composition is contained in a cooking utensil and the cooking utensil is used as a cooking utensil for a microwave oven.

Patent Literature 3 discloses a solder mounting method and a microwave heating apparatus.

### CITATION LIST

### PATENT LITERATURES

Patent Literature 1: JP-A-2017-163015 ("JP-A" means unexamined published Japanese patent application)
Patent Literature 2: JP-A-2013-239459
Patent Literature 3: JP-A-2019-136771

### SUMMARY OF THE INVENTION

### TECHNICAL PROBLEM

The microwave heating has various advantages as described above. However, when soldering or the like of an electronic device is performed using the microwave heating, the sizes of the solder and the electronic device significantly affect the solder melting process. That is, generally, since a minute member does not sufficiently absorb the microwave, the solder in small size is insufficiently melted in some cases. Therefore, when the electronic devices in various sizes are simultaneously mounted, a difference occurs in heating histories of the solder different in size for each component. Therefore, there are technical constraints in the mounting of the electronic device and the like using the microwave heating, and there has been a room for improvement.

In the heating method in which the heat generation pattern on the support is heated to heat the solder on the base disposed on the support corresponding to the heat generation pattern, the heating efficiency is affected by the thickness of the base and the thermal conductivity of the base. Therefore, there are possibly constraints in the base type and the heating condition.

The present invention has an object to provide a mounting wiring board, a mounting wiring board having an electronic device attached thereon, and a method of mounting an electronic device that enable mounting an electronic device with high efficiency and low damage using a standing wave of a microwave.

### MEANS FOR SOLVING THE PROBLEMS

The present invention is defined by the independent claims. Advantageous embodiments are described in dependent claims.

The term "mounting" in the description means that an electric or electronic device having an electrical function is embedded into equipment or an apparatus. Specifically, it means that an electric or electronic device is attached to a wiring board or the like. More specifically, it means a technique to attach an electric or electronic device to an electrode portion disposed on a mounting wiring board. Embedding a circuit board or a wiring into a chassis is included.

The term "electronic device" is used in a broad sense including passive elements such as a resistor, a capacitor, and an inductor, further including sensors such as various measuring elements and an imaging device, optical elements such as a light receiving element and a light emitting element, acoustic elements, and the like, and further including electric components, in addition to electronic devices such as a semiconductor device and an integrated circuit (IC).

### EFFECTS OF THE INVENTION

According to the mounting wiring board, and method of mounting an electronic device of the present invention, it is possible to mount an electronic device with high efficiency and low damage using a standing wave of a microwave.

### BRIEF DESCRIPTION OF DRAWINGS

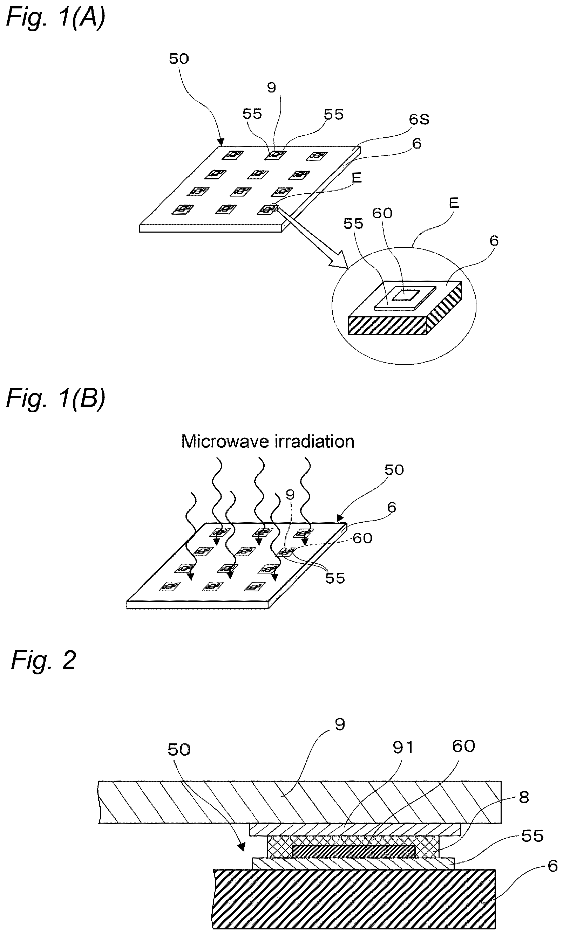

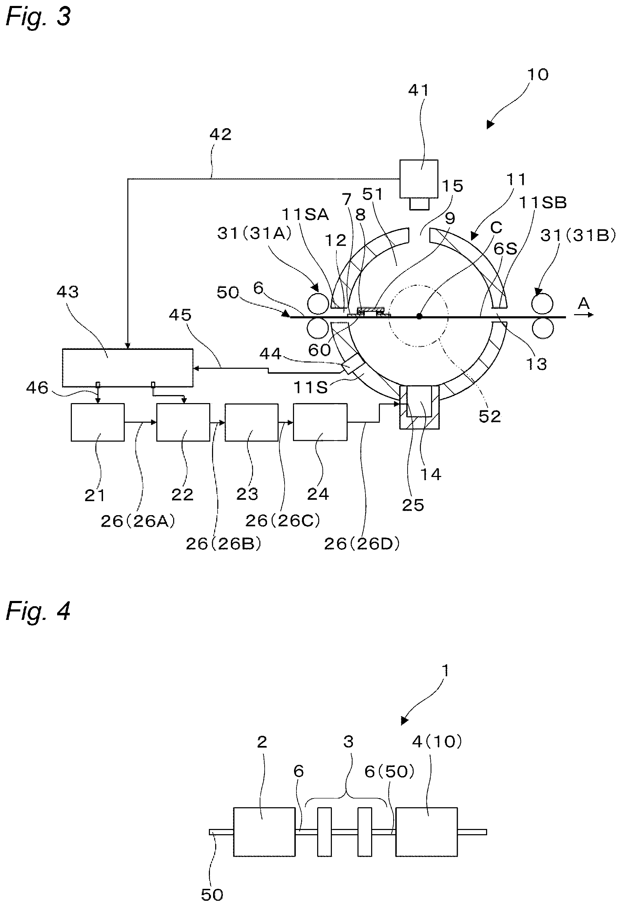

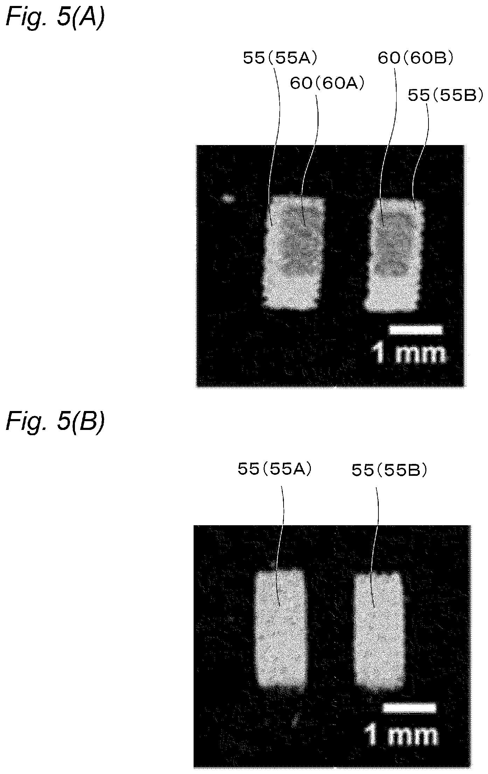

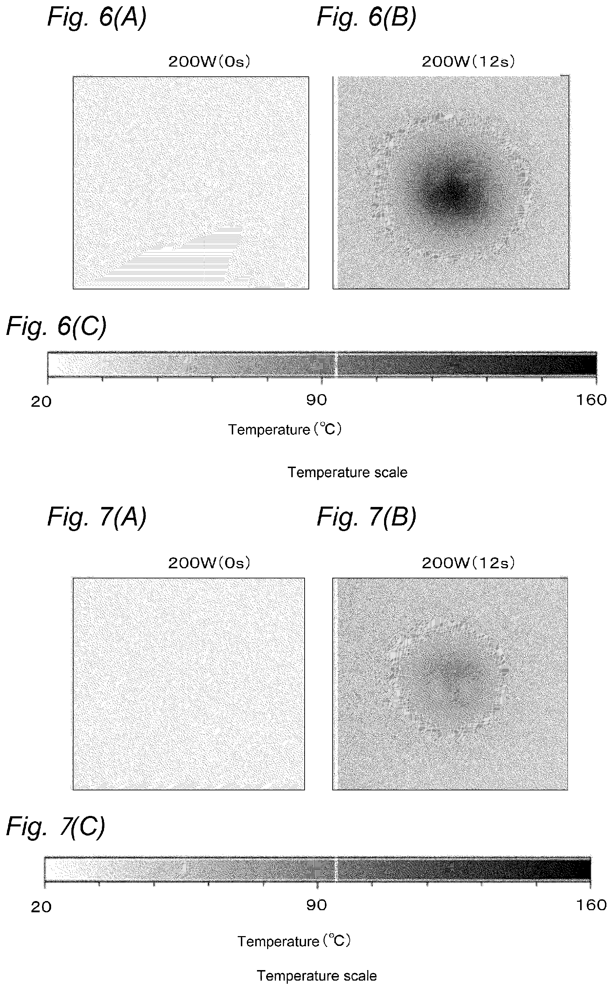

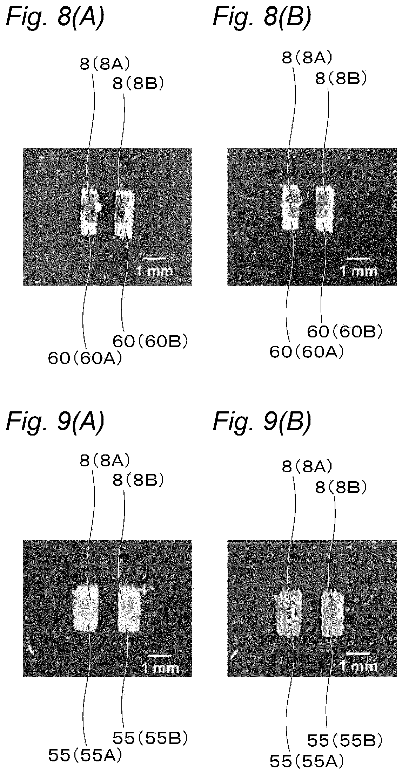

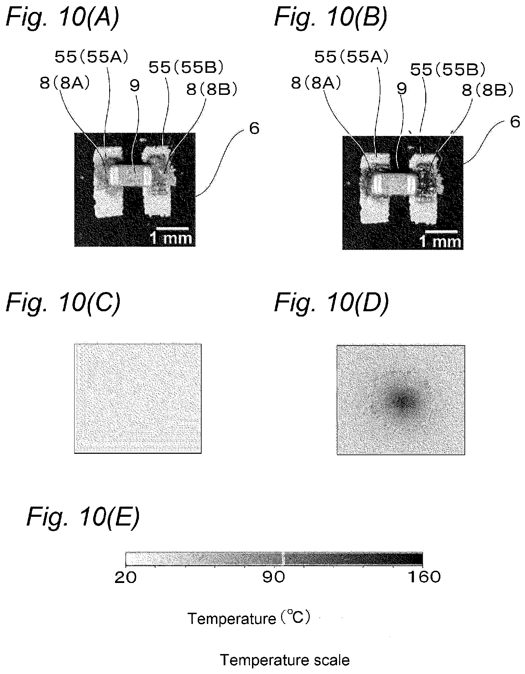

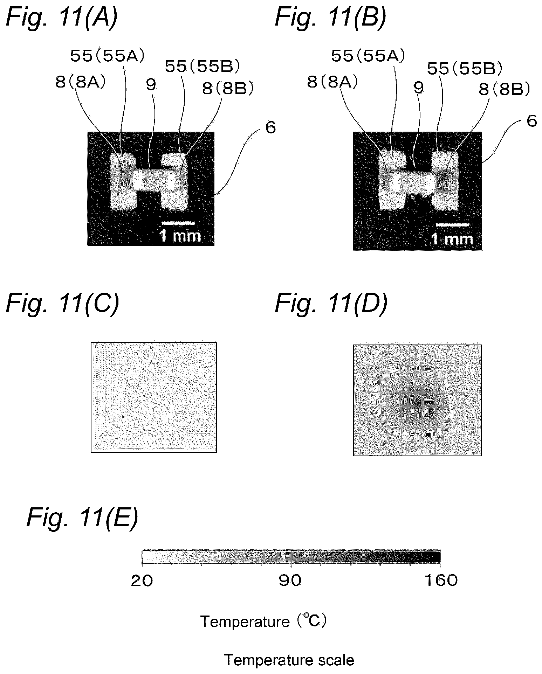

{Fig. 1}
   Fig. 1 includes perspective views schematically showing a preferred example of a mounting wiring board of the present invention, and drawings showing a method of mounting an electronic device. Fig. 1(A) is a perspective view (including a partial cross-sectional perspective view of enlarged electrode portion and heat generation pattern on a base of part E) showing a state after disposing the electronic device on a wiring mounting board via solder and before microwave irradiation. Fig. 1(B) is a perspective view schematically showing a state of performing soldering and mounting by the microwave irradiation.
{Fig. 2}
   Fig. 2 is a partial cross-sectional view showing one embodiment in which the electronic device is mounted on the mounting wiring board of the present invention.
{Fig. 3}
   Fig. 3 is a block diagram schematically showing an example of a preferred entire configuration of a microwave heating apparatus, and is a drawing showing a cavity resonator in schematic cross-sectional view.
{Fig. 4}
   Fig. 4 is a block diagram schematically showing an example of a preferred entire configuration of a soldering and mounting apparatus using a microwave heating apparatus**.**
{Fig. 5}
   Fig. 5(A) is a photographic substitute for a drawing, which shows an embodiment in which a heat generation pattern of nickel was formed on an electrode portion in Example 1. Fig. 5(B) is a photographic substitute for a drawing, which shows an embodiment in which only an electrode portion was formed in Comparative Example 1.
{Fig. 6}
   Fig. 6(A) is a photographic substitute for a drawing, which shows a temperature distribution before a microwave irradiation in the embodiment in which the heat generation pattern of nickel was formed on the electrode portion in Example 1. Fig. 6(B) is a photographic substitute for a drawing, which shows the temperature distribution after the microwave irradiation. Fig. 6(C) is a photographic substitute for a drawing, which shows the temperature scale of Figs. 6(A) and (B).
{Fig. 7}
   Fig. 7(A) is a photographic substitute for a drawing, which shows a temperature distribution before a microwave irradiation on the electrode portion in Comparative Example 1. Fig. 7(B) is a photographic substitute for a drawing, which shows the temperature distribution after the microwave irradiation. Fig. 7(C) is a photographic substitute for a drawing, which shows the temperature scale of Figs. 7(A) and (B).
{Fig. 8}
   Fig. 8(A) is a photographic substitute for a drawing of the base 6 before the microwave heating viewed from the electronic device side in Example 2. Fig. 8(B) is a photographic substitute for a drawing of the base 6 after 5 seconds from the microwave heating viewed from the electronic device side in Example 2.
{Fig. 9}
   Fig. 9(A) is a photographic substitute for a drawing of the base 6 before the microwave heating viewed from the electronic device side in Comparative Example 2. Fig. 9(B) is a photographic substitute for a drawing of the base 6 after 60 seconds from the microwave heating viewed from the electronic device side in Comparative Example 2.
{Fig. 10}
   Fig. 10(A) is a photographic substitute for a drawing of the base 6 before the microwave heating viewed from the electronic device side in Example 3. Fig. 10(B) is a photographic substitute for a drawing of the base 6 after 25 seconds from the microwave heating viewed from the electronic device side in Example 3. Fig. 10(C) is a photographic substitute for a drawing, which shows a temperature distribution of the base 6 including the electronic device and the like before the microwave heating viewed from the electronic device side in Example 3. Fig. 10(D) is a photographic substitute for a drawing, which shows a temperature distribution of the base 6 including the electronic device and the like after 25 seconds from the microwave heating viewed from the electronic device side in Example 3. Fig. 10(E) is a photographic substitute for a drawing, which shows the temperature scale of Figs. 10(C) and (D).
{Fig. 11}
   Fig. 11(A) is a photographic substitute for a drawing of the base 6 before the microwave heating viewed from the electronic device side in Comparative Example 3. Fig. 11(B) is a photographic substitute for a drawing of the base 6 after 70 seconds from the microwave heating viewed from the electronic device side in Comparative Example 3. Fig. 11(C) is a photographic substitute for a drawing, which shows a temperature distribution of the base 6 including the electronic device and the like before the microwave heating viewed from the electronic device side in Comparative Example 3. Fig. 11(D) is a photographic substitute for a drawing, which shows a temperature distribution of the base 6 including the electronic device and the like after 25 seconds from the microwave heating viewed from the electronic device side in Comparative Example 3. Fig. 11(E) is a photographic substitute for a drawing, which shows the temperature scale of Figs. 11(C) and (D).

### MODE FOR CARRYING OUT THE INVENTION

The following describes preferred one embodiment of a mounting wiring board and a microwave heating method for mounting an electronic device to the mounting wiring board of the present invention with reference to the drawings.

As shown in Fig. 1(A), a mounting wiring board 50 includes a base 6 on which electrode portions 55, to which electrodes (terminals, in other words) (not illustrated) of an electronic device are connected, are disposed. Wirings (not illustrated) can be connected to the electrode portions 55. The electrode portion 55 includes a quadrangular heat generation pattern 60 to be heated by a microwave. The heat generation pattern 60 may be disposed on an upper surface of the electrode portion 55, may be disposed in the electrode portion 55, or may be disposed on a lower surface side of the electrode portion 55. In considering the thermal conductivity to an object to be heated 8, the heat generation pattern 60 is preferred to be disposed on the upper surface of the electrode portion 55.

The base 6 is preferred to be formed of a dielectric material, such as a resin, an oxide, and ceramics (inorganic compound compact), easily transmitting the microwave. For example, the base 6 may be a thin material (for example, a sheet and a tape) such as a film and paper, and may be a plate-shaped body having a certain degree of thickness such as a resin substrate, a ceramic substrate, a glass substrate, and an oxide substrate. A metal plate can be used for the base 6. Further, the base 6 may be one in which a surface of a metal plate is coated with the dielectric material.

As the resin, for example, polyimide, polyethylene terephthalate (PET), polytetrafluoroethylene (PTFE), polyethylene naphthalate (PEN), and the like are included. Ceramics such as silicon nitride (SiN) and aluminum oxide (Al₂O₃), glasses such as silicon oxide (SiO₂), and oxides such as iron oxide (Fe₂O₃), tin oxide (SnO), and titanium oxide (TiO₂) are included. Further, manganese chloride (MnCl₂) and the like are included. As the metal plate, an aluminum plate, a copper plate, and the like are included. These bases 6 preferably have heat resistance of the melting point or more of solder.

The heat generation pattern 60 is configured to have an occupation area projected to the upper surface of the electrode portion 55 in plan view smaller than an area of upper surface of the electrode portion. For example, the electrode portion upper surface is a surface in the heat generation pattern 60 side. When the object to be heated (hereinafter also referred as solder) 8 (see Fig. 2) is formed on such an electrode portion 55, since the heat generation pattern 60 does not completely cover the electrode portion 55, the electrical connection between the solder 8 and the electrode portion 55 is facilitated. For example, a proportion of the occupation area of the heat generation pattern 60 to the area of the upper surface of the electrode portion 55 only needs to have a magnitude enough to obtain a heat generation amount for melting the solder 8 by the heat generation pattern 60. For example, the occupation area of the heat generation pattern 60 to the upper surface of the electrode portion 55 can be set to 90% or less, preferably 70% or less, further preferably 50% or less, and can be set to 40% or less. From the aspect of securing the melting of the solder 8, the proportion of the occupation area of the heat generation pattern 60 is usually 5% or more, and actually 10% or more. The above-described occupation area of the heat generation pattern 60 is substantially a contact area between the electrode portion 55 and the heat generation pattern 60.

An occupation area of the heat generation pattern 60 projected to a lower surface of the solder 8 in plan view smaller than an area of the lower surface of the solder 8 (see Fig. 2) before the melting or after the melting, preferably before the melting. This enables directly contacting the heat generation pattern 60 and the solder 8 to be electrically connected. For example, a proportion of the occupation area of the heat generation pattern 60 to the area of the lower surface of the solder 8 in plan view has a magnitude enough to obtain the heat generation amount for melting the solder 8 by the heat generation pattern 60, preferably 90% or less, more preferably 70% or less, further preferably 50% or less, and can be set to 40% or less. From the aspect of securing the melting of the solder 8, the occupation area is usually 5% or more, and actually 10% or more.

Thus, the heat generation pattern 60 is preferred to be formed so as to have the size for generating the heat amount enough to melt the solder 8 without hindering the electrical connection between the solder 8 after the melting and the electrode portion 55.

The shape and the formation material of the heat generation pattern 60 are not specifically limited, one having desired microwave heating characteristics can be appropriately used depending on the purpose.

For example, the shape of the heat generation pattern 60 is preferably a shape corresponding to the shape of the object to be heated 8. In the drawing, a quadrangle in plan view is employed. The shape of the heat generation pattern 60 may be various shapes matched to the shape of the object to be heated 8. For example, it may be a similarity shape to the shape of the object to be heated 8. One heat generation pattern 60 or a plurality of heat generation patterns 60 may be disposed on the electrode portion 55. Its arrangement pattern is preferred to correspond to the arrangement pattern of the object to be heated.

The heat generation pattern 60 is preferably a thin film pattern of a magnetic material or a conductor including a magnetic material. Accordingly, the heat generation pattern 60 is easily heated by an action of a magnetic field. The thin film pattern may be a laminated pattern or a single layer pattern.

The material of the heat generation pattern 60 includes the following materials. The following heat generation pattern 60 can be heated irrespective of the size.

For example, the material of the heat generation pattern 60 preferred to be subjected to a magnetic field heating includes a magnetic material. The magnetic material usually means a ferromagnet. The ferromagnet includes iron, cobalt, nickel, or an alloy of them, or a ferrite exhibiting a ferromagnetic property. Ferrite is a generic term for ceramics mainly containing iron oxide, and is a sintered body in which one or more of cobalt, nickel, manganese, and the like are mixed. The material of the heat generation pattern that can be heated by the magnetic field heating can include a metal conductor, a dielectric material (insulator), and the like, which are non-magnetic bodies. Further, any one of the ferromagnets and the non-magnetic bodies, or a combination of the two or more can be used as the formation material of the heat generation pattern. The heat generation pattern 60 can be formed of, for example, a thin film, a collective body of a powder, or a liquid. The heat generation pattern 60 may be embedded in the electrode portion 55, or may be disposed on the lower surface side of the electrode portion 55.

The heat generation pattern 60 caused to perform heat generation by an eddy-current loss (resistance by an induced current) due to a magnetic field formed by the microwave irradiation includes a non-magnetic metal, and includes, for example, a silver paste pattern, a copper paste pattern, a gold paste pattern, and the like.

The heat generation pattern caused to perform heat generation mainly by a magnetic loss due to the magnetic field formed by the microwave irradiation includes a nickel paste pattern. Additionally, an iron alloy powder pattern, a ferrosoferric oxide (Fe₃O₄) powder pattern, a sendust (iron-silicon-aluminum) alloy powder pattern, and the like are included.

Next, a method of mounting the electronic device to the mounting wiring board will be described below.

As shown in Fig. 2, the above-described mounting wiring board 50 in which the heat generation pattern 60 is formed on the electrode portion 55 disposed on the base 6 is prepared.

Then, the solder 8 is formed so as to cover the heat generation pattern 60. Further, after an electrode 91 of an electronic device 9 is disposed on the solder 8, as shown in Fig. 1(B), the heat generation pattern 60 is heated by a single-mode standing wave of a microwave. Since the base 6 itself is formed of a material restricted in microwave absorption, the base 6 itself is hardly heated regardless of the microwave irradiation, and the heat generation pattern 60 is selectively heated. Note that even when the base 6 is heated, the heating temperature can be set to a temperature lower than a temperature adversely affecting, for example, causing a thermal damage, the base 6, the electronic device 9, and the like. The heat generation pattern 60 is heated to the melting temperature of the solder 8 or more by the microwave heating. Then, the solder 8 is heated and melted by the heat conduction from the heat generation pattern 60. Thus, the solder 8 is selectively and high efficiently heated in a short time. The heating is ended by taking out the mounting wiring board 50 from a microwave irradiation region. Consequently, the mounting wiring board 50 is removed from the microwave irradiation space, and the melted solder 8 is cooled and solidified, thereby soldering the electrode 91 (see Fig. 2) of the electronic device 9 and the electrode portion 55. Thus, the electronic device 9 is soldered and mounted to the mounting wiring board 50.

In the above-described microwave heating, since the base 6 is hardly heated, a low melting point base can be used for the base 6. The peripheral area of the heat generation pattern 60 is heated by the heat generation of the heat generation pattern 60. The heating temperature can be set to a temperature at which the solder 8 melts and the temperature equal to or less than the heat-resistant temperature of the base 6 by controlling an output or the like of the microwave. Therefore, the base 6 can avoid the thermal damage.

The soldering and mounting of the electronic device 9 by the microwave heating is performed using the mounting wiring board 50 as described above. That is, the solder 8 can be selectively and efficiently heated in a short time by the heat generation pattern 60. Therefore, the heating damage of the wiring (not illustrated) other than the mounted portion on the base 6 and the electronic device 9 can be reduced. Moreover, even when it is a micro-sized (for example, about several millimeters) electronic device, the electronic device 9 can be mounted to the base 6 on which the electrode portion 55 is formed. Since the temperature rise behavior can be controlled by the material, the size, the shape, and the like of the heat generation pattern 60, the heating state can be controlled by the heat generation pattern 60. Consequently, the electronic device 9 can be mounted to the electrode portions 55 formed in various printing patterns, thus leading to the cost reduction. By adjusting the pattern size of the heat generation pattern 60 for each electronic device, the heating state (for example, heating temperature and temperature increase rate) of the solder can be made constant. Moreover, the electronic devices in various sizes can be collectively mounted irrespective of the size of the electrode portion 55. For example, the heat generation pattern 60 having the occupation area of about 40% to the area of the upper surface of the electrode portion 55 in plan view is disposed. Accordingly, the solder 8 formed on the electrode portion 55 having a large area (for example, 400 mm²) as well as the solder 8 formed on the electrode portion 55 having a small area (for example, 0.09 mm²) are heated to the same temperature and melted. Consequently, even the solder 8 different in area in plan view can be simultaneously heated to the melting temperature by the heat generation pattern 60. The values of area such as a large area, a small area, and a solder area, are merely examples, and can be appropriately changed.

Next, a microwave heating apparatus 10 appropriate for heating the heat generation pattern 60 by the microwave will be described in detail with reference to Fig. 3.

### [Microwave heating apparatus]

As shown in Fig. 3, a microwave heating apparatus 10 includes a cavity resonator (hereinafter also referred to as the (cylindrical) cavity resonator) 11 having a microwave irradiation space 51. The cavity resonator 11 may be a cylindrical type or a polygonal tube type having two parallel surfaces facing each other with a tube central axis as the center. That is, it is only necessary that a standing wave having a magnetic field strength maximum and uniform on a central axis C of the cavity resonator 11 can be formed. The following describes the cylindrical cavity resonator.

The cavity resonator 11 shown in Fig. 3 forms a standing wave in, for example, TM₁₁₀ mode where the magnetic field strength is maximum and uniform along a cylinder central axis (hereinafter referred to as the central axis) C. Hereinafter, the central axis of the cavity resonator 11 and the central axis of the microwave irradiation space 51 are used in the same meaning.

The cavity resonator 11 includes an inlet 12 provided in a barrel portion wall 11SA of the cavity resonator 11, and an outlet 13 provided in a barrel portion wall 11SB facing the barrel portion wall 11SA, the inlet 12 and the outlet 13 facing each other across the cylinder central axis C of the cavity resonator. The inlet 12 and the outlet 13 are preferred to be formed in slit shapes with widths allowing the mounting wiring board 50 on which the electronic device 9 is placed via the solder 8 and the like to pass through. A transfer mechanism 31 that transfers the mounting wiring board 50 on which the electronic device 9 is placed via the solder 8 to a magnetic field region 52 in which an electric field becomes minimum and a magnetic field strength becomes maximum and uniform in the cavity resonator 11 is disposed. The magnetic field region 52 has the magnetic field strength decreased outward from the cylinder central axis C. In the drawing, a region in which the magnetic field strength is 3/4 or more of the maximum value is schematically shown by a two-dot chain line as an example.

The base 6 is transferred in the microwave irradiation space 51 from the inlet 12 by the transfer mechanism 31, a heating process (firing process) is performed, and the treated base 6 is transferred out from the outlet 13. The term "maximum" is a meaning also including a portion where the magnetic field strength at and around a maximum point is greater than other regions. For example, it is a region having equal to or greater than 3/4 of the maximum value and including the maximum value. Moreover, the electrode portion 55 may be a single conductive pattern, or a collective pattern being a collection of a plurality of conductive patterns. Furthermore, the electrode portion 55 may be a combined pattern including another pattern in a conductive pattern.

For example, in a case of the cylindrical cavity resonator 11 where a standing wave in TM₁₁₀ mode is generated, a magnetic field region 52 is a space where the electric field strength is minimum and the magnetic field strength is maximum at the central axis C and the magnetic field is uniform along the central axis C. The side of the heat generation pattern 60 of the base 6 is preferably disposed in such a manner as to pass the magnetic field region 52, that is, the central axis C. Accordingly, the inlet 12 and the outlet 13 through which the support 50 and the base 6 pass are preferred to be provided to barrel portion walls 11SA, 11SB of the cylindrical cavity resonator 11 at positions opposed across the central axis C. In other words, the inlet 12, the central axis C, and the outlet 13 are preferably disposed at positions including the same plane.

A microwave generator 21 is disposed for the cavity resonator 11 to supply microwaves to the cavity resonator 11. The microwave frequency is generally 0.3 to 300 GHz, and especially the S band ranging from 2 to 4 GHz is often used for the microwave frequency. Alternatively, 900 to 930 MHz, 5.725 to 5.875 GHz or the like may be used. However, other frequencies can also be used.

In the microwave heating apparatus 10, to the cavity resonator 11, the microwave generated by the microwave generator 21 is supplied to the microwave irradiation space 51 in the cavity resonator 11 from a microwave supply port 14, thereby forming a standing wave in the microwave irradiation space. The heat generation pattern 60 of the base 6 is heated at a part (the central axis C of the cavity resonator 11 and its proximity) in which the magnetic field strength of the standing wave becomes maximum and the electric field strength becomes minimum. Then, the solder 8 on the base 6 is heated by the heat conduction from the heat generation pattern 60 (see Figs. 1 and 2).

In the above microwave heating apparatus 10, it is preferable that a microwave that is supplied from the microwave generator 21 is adjusted in frequency, and then supplied. The adjustment of the frequency allows stably controlling the magnetic field strength distribution of a standing wave formed in the cavity resonator 11 into a desired distribution state, and adjusting the intensity of the standing wave by the output of the microwave. In other words, the heating state of the heat generation pattern 60 can be controlled.

The frequency of a microwave that is supplied from the microwave supply port 14 can form a specific single-mode standing wave in the microwave irradiation space 51.

The constitution of the microwave heating apparatus 10 will be described, in order.

### <Cavity resonator>

The cylindrical cavity resonator (cavity) 11 used for the microwave heating apparatus 10 is not particularly limited as long as the cavity resonator 11 includes one microwave supply port 14 and forms a single-mode standing wave when a microwave is supplied. The microwave irradiation space 51 of the cavity resonator is not limited to the cylindrical type shown in the drawings. In other words, the cavity resonator may be a cavity resonator of not the cylindrical type but a polygonal tube type having two parallel surfaces facing each other with the central axis as the center. For example, the cavity resonator may be of a tube type of a regular even-sided polygon whose cross section in the direction perpendicular to the central axis is, for example, a square, a regular hexagon, a regular octagon, a regular dodecagon, or a regular hexadecagon, or a polygonal tube type of a shape obtained by crushing a tube type of a regular even-sided polygon between two surfaces facing across the central axis. In a case of the cavity resonator of the above polygonal tube type, corners inside the cavity resonator may be rounded. Moreover, a microwave irradiation space may be a cavity resonator having a space of, for example, a column or ellipsoid where the above roundness is increased, other than the above tube type.

Even such a polygon can realize effects similar to the cylindrical type (in other words, a standing wave whose magnetic field strength is maximum and uniform at the central axis can be formed).

A size of the cavity resonator 11 can be appropriately designed according to a purpose. The cavity resonator 11 desirably has a small electric resistivity. The cavity resonator 11 is usually made of a metal, and as an example, use can be made of aluminum, copper, iron, magnesium or an alloy of these; an alloy such as brass and stainless steel; or the like. Alternatively, a resin, ceramic, or metal surface may be coated by, for example, plating or vapor deposition with a material having a small electric resistivity. A material including silver, copper, gold, tin, or rhodium can be used for the coating.

### <Transfer Mechanism>

A transfer mechanism 31 preferably includes a supply-side transfer unit 31A, a sending-side transfer unit 31B, or both of them.

Alternatively, the supply part 31, the inlet 12, and the outlet 13 may not be provided. In this case, it is possible to place a base 6 in advance at a position where in the cavity resonator the magnetic field is maximum, treat the base 6 for an appropriate time, and then stop a microwave, open a part of the cavity resonator, and take out the base 6 if necessary.

Alternatively, it is also possible to move the cavity resonator itself without using a specific transfer mechanism as the supply part 31. In this case, it is suitable to fix the mounting wiring board 50, and move the cavity resonator itself parallel to the base surface 6S in such a manner as not to displace the position where in the cavity resonator the magnetic field is maximum from the base surface 6S on which the heat generation pattern 60 is formed.

The transfer mechanism 31 is preferably capable of moving the mounting wiring board 50 up and down in a direction perpendicular to a vibration direction of the magnetic field (for example, a direction perpendicular to the base surface when the vibration of the magnetic field is assumed as a vibration on the surface of the base 6) in the cavity resonator 11. In other words, it is preferred that moving to up and down in the direction perpendicular to the central axis C of the cavity resonator 11 (for example, vertical direction) is allowed. In this manner, the mounting wiring board 50 moves up and down; accordingly, it is possible to prevent a thick device 9 from entering an electric field formation region where the strength of the electric field is strong. The vertical travel distance is preferably ±1 cm, more preferably ± 3 cm, still more preferably ± 5 cm from the central axis C of the cavity resonator 11. When it is possible to make a large movement, it is possible to cause even a considerably thick device to avoid the electric field formation region. Consequently, the generation of a spark can be prevented. The above configuration can be obtained by, for example, adding a height adjustable mechanism to the nip roll constituting the transfer mechanism 31. In this case, the inlet 12 and the outlet 13 of the cavity resonator 11 need to be open with a size equal to the travel distance of the mounting wiring board 50 and the electronic device 9. Moreover, the inlet 12 and the outlet 13 are preferably provided with a metal plate that narrows the openings of the inlet 12 and the outlet 13 in accordance with the vertical movement of, for example, the base 6 to prevent the leakage of a microwave.

### <Microwave supply>

It is preferable to use a microwave generator 21, a microwave amplifier 22, an isolator 23, an impedance matcher 24, and an antenna 25, each for supplying the microwave.

The microwave supply port 14 is provided in or near a wall surface (an inner surface of the cylinder) parallel to the central axis C of the cavity resonator 11. In one embodiment, the microwave supply port 14 includes the antenna 25 that can apply a microwave. Fig. 3 shows the microwave supply port 14 using a coaxial waveguide converter. In this case, the antenna 25 is an electric field driven monopole antenna. At this point, an iris (not illustrated) may be used as an appropriate opening between the microwave supply port 14 and the cavity resonator 11 to effectively form a standing wave. Moreover, the antenna may be installed directly on the cavity resonator 11 without using the wave guide tube 14. In this case, a loop antenna (not illustrated) serving as a magnetic field driven antenna may be installed near a side wall of the cavity resonator. Alternatively, it is also possible to install an electric field driven monopole antenna on a top surface or undersurface of the cavity resonator.

The antenna 25 receives the supply of a microwave from the microwave generator 21. Specifically, it is preferable that the microwave amplifier 22, the isolator 23, the matcher 24, and the antenna 25 are connected sequentially to the microwave generator 21. Cable 26 (26A, 26B, 26C and 26D) is used for each connection.

For example, a coaxial cable is used for each cable 26. In this configuration, a microwave emitted from the microwave generator 21 is supplied by the antenna 25 from the microwave supply port 14 into the microwave irradiation space 51 in the cavity resonator 11 via each cable 26.

### [Microwave generator]

As the microwave generator 21 for use in the microwave heating apparatus 10, for example, use can be made of the microwave generator, such as a magnetron, or the microwave generator using a solid-state semiconductor device. From the viewpoint of capable of finely adjusting the microwave frequency, it is preferable to use the VCO (voltage-controlled oscillator), VCXO (voltage-controlled crystal oscillator), or PLL (phase-locked loop) oscillator.

### [Microwave amplifier]

The microwave heating apparatus 10 includes a microwave amplifier 22. The microwave amplifier 22 has the function of amplifying the output of a microwave generated by the microwave generator 21. The configuration is not particularly restricted. However, for example, it is preferable to use a solid-state semiconductor device including a high-frequency transistor circuit.

### [Isolator]

The microwave heating apparatus 10 includes an isolator 23. The isolator 23 prevents the influence of a reflected wave generated within the cavity resonator 11 and protects the microwave generator 21. That is, the isolator 23 causes microwaves to be supplied in one direction (the antenna 25 direction). If there is no risk that the microwave amplifier 22 and the microwave generator 21 are damaged by reflected waves, it is not necessary to install the isolator.

### [Matcher]

The microwave heating apparatus 10 includes the matcher 24. The matcher 24 matches (adjusts) the impedance from the microwave generator 21 to the isolator 23 and the impedance of the antenna 25. If there is no risk that the microwave amplifier 22 and the microwave generator 21 are damaged even when a reflected wave is generated due to a mismatch, or if an adjustment can be made so as to avoid the mismatch, it is not necessary to install the matcher.

### <Control system>

The above microwave heating apparatus 1 is provided with a thermal image measurement apparatus (thermo-viewer) 41, or a radiation thermometer (not illustrated), which measures the temperature of the object 8 to be heated. The cavity resonator 11 is preferably provided with a window 15 for measuring the temperature distribution of the base 6 including an object to be heated or the like with the thermal image measurement apparatus 41 or radiation thermometer (not illustrated). A measurement image of the temperature distribution measured by the thermal image measurement apparatus 41, or the temperature information measured by the radiation thermometer, is transmitted to a control unit 43 via a cable 42. Furthermore, the barrel wall 11S of the cavity resonator 11 is preferably provided with an electromagnetic wave sensor 44. A signal in accordance with electromagnetic field energy in the resonator 11 detected by the electromagnetic wave sensor 44 is transmitted to the control unit 43 via a cable 45. The control unit 43 can detect the formation state (resonance state) of a standing wave generated in the microwave irradiation space 51 of the cavity resonator 11 on the basis of the signal of the electromagnetic wave sensor 44. When a standing wave has been formed, that is, when resonance is occurring, the output of the electromagnetic wave sensor 44 increases. The oscillatory frequency of the microwave generator is adjusted in such a manner as to maximize the output of the electromagnetic wave sensor 44. Accordingly, it is possible to control the microwave frequency in such a manner as to agree with the resonance frequency of the cavity resonator 11. The resonance frequency changes depending on the state (for example, the insertion state and the temperature) of the object to be heated and, accordingly, the control needs to be performed at appropriate intervals. When the change is made quickly, when the object to be heated is supplied at high speed, and when the supply speed changes, it is desirable to control the microwave frequency at intervals of 1 millisecond to 1 second. When the change is small, for example, when the object to be heated is fixed, and when the supply speed does not change, it is desirable to perform the control at intervals of 10 seconds to 1 minute. Alternatively, there is also a case where when the resonance frequency is obtained once before heating, it is not necessary to always perform the control afterwards.

In the control unit 43, the frequency of a microwave at which a standing wave of a fixed frequency occurs in the cavity resonator 11 can be fed back to the microwave generator 21 via a cable 46 on the basis of the detected frequency. The control unit 43 can precisely control the frequency of a microwave supplied from the microwave generator 21 on the basis of the feedback. A standing wave can be stably generated in the cavity resonator 11 in this manner. Therefore, the heat generation pattern 60 can be uniformly heated by a standing wave with high efficiency and high repeatability. Moreover, the control unit 43 instructs the microwave amplifier 22 to output a microwave; accordingly, it is possible to make an adjustment in such a manner as to be able to supply a microwave of a fixed output to the antenna 25. Alternatively, it is also possible to adjust the attenuation factor of an attenuator (not illustrated) installed between the microwave generator 21 and the microwave amplifier 22 on an instruction of the control unit 43 without changing the amplification factor of the microwave amplifier 22. Feedback control may be performed on a microwave output to adjust the temperature of an object to be heated to a target temperature on the basis of an instructed value of the thermal image measurement apparatus 41 or the radiation thermometer. When an apparatus that can emit a large output, such as a magnetron, is used as the microwave oscillator 21, the control unit 43 may instruct the microwave generator 21 to adjust the microwave output.

As a control method that does not use the electromagnetic wave sensor 44, the magnitude of a reflected wave of the cavity resonator 11 may be measured to use a measurement value. The isolation amount obtained from the isolator 23 can be used to measure a reflected wave. The frequency of the microwave generator is adjusted in such a manner as to minimize a reflected wave signal; accordingly, microwave energy can be efficiently supplied to the cavity resonator 11.

### <Heating of heat generation pattern>

In the microwave heating apparatus 10, the heat generation pattern 60 is composed of a magnetic material or a conductor including a magnetic material. When such a heat generation pattern 60 is disposed along the portion where the magnetic field strength of the standing wave formed in the cavity resonator 11 is locally maximized, more efficient heating can be performed. For example, the substrate 6 is supplied from the inlet 12 and discharged from the outlet 13 such that the surface 6S (see Fig. 1) of the base 6 on which the heat generation pattern 60 is formed passes through the central axis C of the cavity resonator 11.

In the microwave heating apparatus 10, the frequency of the standing wave is not particularly limited as long as the standing wave can be formed in the cavity resonator 11. For example, when the microwave is supplied from the microwave supply port 14, the frequency is preferably set to a frequency at which the above-described standing wave in TM₁₁₀ mode is formed in the cavity resonator 11. As a mode of forming a maximum region of the magnetic field strength at the central axis C, TMₙ₁₀ (n is an integer of 1 or more) modes (for example, modes of TM₂₁₀, TM₃₁₀) and TE₁₀ₙ (n is an integer of 1 or more) modes are included. A standing wave in TM₁₁₀ is preferable in the respect that the portion of the maximum magnetic field strength can be efficiently formed along the central axis C of the cavity resonator 11.

In the case of a TE₁₀ₙ (n is an integer of 1 or more) mode, a TE₁₀₁ mode where n = 1 is the most preferable, or TE₁₀₂ and TE₁₀₃ modes are also acceptable.

The cavity resonator 11 is ordinarily designed so that the resonance frequency is within an ISM (Industry Science Medical) band. However, when including a mechanism capable of suppressing the level of the electromagnetic wave radiated from the cavity resonator 11 or the whole apparatus so as not to affect the safety to the surroundings, the communication, and the like, the design with the frequency other than the ISM band is allowed.

When, in the above microwave heating apparatus 10, a microwave is supplied into the cavity resonator 11 and a specific standing wave is formed, it is possible to generate a magnetic field at the central axis C of the cavity resonator 11 and maximize the magnetic field, and also it is possible to uniformly distribute the magnetic field in the central axis direction. At this time, in the region along the central axis C in which the maximum and uniform magnetic field is generated, in fact, the electric field is not generated. Therefore, by transferring the base 6 including the electrode portion 55 in from the inlet 12 and transferring out from the outlet 13 passing through the central axis C, the magnetic field that becomes maximum at the central axis C can be uniformly formed in the width direction of the support 50 without generating the spark (arc discharge) due to the electric field. The heating is performed by the heat generation caused by the magnetic loss due to the action of the magnetic field and/or the heat generation by the induced current generated in the heat generation pattern 60 by the magnetic field of the magnetic field region 52.

In the induced heating, when the base 6 comprises a resin, and a heat generation pattern 60 is disposed on the base 6, the heat generation pattern 60 is heated, but the resin base 6 is not heated. Generally, the resin has almost no magnetic loss. Even if a magnetic field is applied, an induced current is not generated in the resin and therefore the resin is not heated. On the other hand, an induced current is generated in the heat generation pattern 60 and therefore the heat generation pattern 60 is heated. In this manner, the heat generation pattern 60 can be selectively heated. By the heating of the heat generation pattern 60, the object to be heated (solder) 8 disposed on the heat generation pattern 60 is heated and melted by the heat conduction. Then, the electrode 91 (see Fig. 2) of the electronic device 9 is joined via the solder 8 melted and solidified on the electrode portion 55, thereby mounting the electronic device 9.

As described above, in the microwave heating apparatus 10, for example, the use of the cylindrical cavity resonator 11 that forms a standing wave in TM₁₁₀ mode allows a magnetic field to be concentrated at the central axis C. Accordingly, this region becomes a region where the magnetic field is maximum, and the magnetic field strength is uniform in the central axis direction. Hence, the controllability (uniformity) of the temperature to the heat generation pattern 60 that passes the central axis C increases. Moreover, the frequency and output of a microwave that forms a standing wave is controlled; accordingly, a constant standing wave can be always formed. Hence, temperature controllability is further improved and further uniform heating can be realized.

The electromagnetic wave sensor 44 can correctly detect a signal in accordance with electromagnetic field energy in the cavity resonator 11. Hence, the formation state (resonance state) of a standing wave that has been generated in the cavity resonator 11 on the basis of the detected signal in accordance with the electromagnetic field energy can be detected. The control unit 43 controls the frequency of a microwave in such a manner as to cause stable resonance on the basis of the detection information. In this manner, it is possible to stably generate a standing wave in the cavity resonator 11. Therefore, it is possible to efficiently heat the heat generation pattern 60 to a desired hating state with the standing wave and stably maintain the formation state of the standing wave in the cavity resonator.

Next, one preferred embodiment of the microwave heating method applicable to the microwave heating in the above-described method of mounting the electronic device will be described with reference to Figs. 1 to 3.

The mounting wiring board 50 of the present invention is prepared, and the solder 8 as the object to be heated is formed via the heat generation pattern 60 on the electrode portion 55. Further, the electronic device 9 is placed while the electrode 91 of the electronic device 9 is brought in contact with the solder 8.

Subsequently, the mounting wiring board 50 on which the electronic device 9 is placed is transferred in the cavity resonator 11 by the transfer mechanism 31.

Then, the standing wave that forms the magnetic field region in which the magnetic field strength becomes uniform and maximum along the cylinder central axis C is formed in the cylindrical cavity resonator 11, thereby heating the heat generation pattern 60, and the solder 8 is heated by the heat generation of the heat generation pattern 60. The solder 8 is melted by the heating, and subsequently solidified, thereby joining the electrode (not illustrated) of the electronic device 9 to the electrode portion 55 via the solder 8. That is, the soldering is performed, thus mounting the electronic device 9 to the base 6.

The above standing wave is preferably in TMₙ₁₀ (n is an integer of 1 or more) mode or TE₁₀ₙ (n is an integer of 1 or more) mode, and more preferably TM₁₁₀ mode or TE₁₀₁ mode.

In the above-described microwave heating method, it is preferred that the frequency of the microwave supplied to the cavity resonator 11 is adjusted corresponding to the change of the resonance frequency of the standing wave formed in the cavity resonator 11 to maintain the formation state of the standing wave in the cavity resonator 11. This adjustment can be automatically performed. The control of the standing wave is as described in the control system.

Next, a specific example of an apparatus configuration of a soldering and mounting apparatus 1 including the microwave heating apparatus 10 will be described below with reference to Fig. 4.

As shown in Fig. 4, a microwave heating apparatus 10 is provided with a first group apparatus 2 and a second group apparatus 3 in the upstream of the microwave heating apparatus 10.

The first group apparatus 2 is an apparatus relating to forming the electrode portion 55 and the heat generation pattern 60 (see Fig. 1) on the base 6. The second group apparatus 3 is an apparatus that forms the solder 8 on the electrode portion 55 and places the electronic device 9. As a third group apparatus 4, the microwave heating apparatus 10 is used. Furthermore, a downstream apparatus (not illustrated) that performs postprocessing is preferably provided.

These apparatuses are preferably disposed in the order of the first group apparatus 2, the second group apparatus 3, the third group apparatus 4, and the downstream apparatus. Alternatively, it is also preferable that the first group apparatus 2 to the third group apparatus 4 and the downstream apparatus be disposed around a transfer apparatus (not illustrated). These first group apparatus 2 to third group apparatus 4, and the downstream apparatus are collectively referred to as the soldering and mounting apparatus 1 in other words.

An example of the apparatus placement of the above soldering and mounting apparatus 1 is described below with reference to Fig. 4 in more detail.

As shown in Fig. 4, the first group apparatus 2 of the soldering and mounting apparatus 1 includes a printing apparatus for forming an electrode portion 55 (see Fig. 2) and a drying apparatus. The printing apparatus includes the above primer/adhesive layer printing apparatus and pattern printing apparatus for the electrode portion 55. The primer/adhesive layer printing has the effect of improving adhesion between the base 6 and the electrode portion 55. The pattern printing apparatus for the electrode portion 55 forms the electrode portion 55 on the base 6 by printing. Moreover, the drying apparatus includes a drying apparatus that performs a drying step after printing the primer/adhesive layer printing and a drying step after printing the electrode pattern.

Moreover, the first group apparatus 2 includes a printing apparatus for forming the heat generation pattern 60 (see Fig. 2) and a drying apparatus. The printing apparatus includes the above primer/adhesive layer printing apparatus and pattern printing apparatus for the heat generation pattern. The primer/adhesive layer printing has the effect of improving adhesion between the electrode portion 55 and the heat generation pattern 60. Moreover, the drying apparatus includes a drying apparatus that performs a drying step after printing the primer/adhesive layer printing and a drying step after printing the heat generation pattern. Examples of the above drying apparatuses include heating apparatuses such as an infrared heating apparatus, a hot air heating apparatus, and a hot plate. The above drying apparatus can also be shared.

The second group apparatus 3 includes a solder paste application apparatus, and an electronic device mounting apparatus. The solder paste application apparatus prints a solder paste pattern to be the solder 8 (refer to Fig. 2) on the electrode portion 55 (refer to Fig. 2), and forms the solder 8. The solder paste application apparatus includes, for example, a stencil printing apparatus, a screen printing apparatus, or a dispenser apparatus. The electronic device mounting apparatus mounts the electronic device 9 (refer to Fig. 2) on the electrode portion 55 via the solder 8 before melting. The second group apparatus 3 preferably includes a solder resist forming apparatus.

The third group apparatus 4 is a microwave heating apparatus 10 (refer to Fig. 3) including one or more cavity resonators. This third group apparatus 4 selectively performs the microwave heating of the heat generation pattern 60 formed in the upper side, thereby heating and melting the solder 8 disposed at the position corresponding to the heat generation pattern 60 by the heat conduction from the heat generation pattern 60. A case of using one cavity resonator is described below. However, two or more (a plurality of) cavity resonators may be disposed in series. For example, while not illustrated, in the downstream of the third group apparatus 4 in which the microwave heating apparatus 10 (10A) is disposed, a fourth group apparatus including another microwave heating apparatus 10 (10B) may be disposed. In this case, the first group apparatus 2 and the second group apparatus 3 are similar to those described above.

In the downstream apparatus (not illustrated), for example, a cleaning apparatus as a flux removal apparatus, or the like is preferably disposed.

The base 6 is transferred by the transfer mechanism (not illustrated) in the order of the first group apparatus 2, the second group apparatus 3, and the microwave heating apparatus (the third group apparatus 4). Each apparatus continuously performs a process on the base 6.

The soldering and mounting method using the microwave heating method is preferred to be performed using the above-described soldering and mounting apparatus 1.

Firstly, the electrode portion 55 (see Figs. 1 and 2) printed (for example, screen printed) on the base 6 is preliminarily dried by the first group apparatus 2. For example, a hot plate is used as the drying apparatus of the first group apparatus 2. The printed electrode portion 55 is, for example, dried at 10°C to 100°C for 1 second to 60 minutes, using the hot plate. This preliminary drying is not particularly restricted as long as the temperature is equal to or less than the firing temperature of the electrode portion 55 and the heat resistant temperature of the base 6. It is preferable to perform the preliminary drying until a solvent component included in the electrode portion 55 evaporates and dries. In the above preliminary drying, the hot plate is used. Note that a heating apparatus for drying other than the hot plate can be used.

Next, the heat generation pattern 60 (see Figs. 1 and 2) is printed (for example, screen printed) on the electrode portion 55, and is preliminarily dried. In this case, for example, a hot plate is used as the drying apparatus. The printed heat generation pattern 60 is, for example, dried at 10°C to 100°C for 1 second to 60 minutes, using the hot plate. This preliminary drying is not particularly restricted as long as the temperature is equal to or less than the firing temperature of the heat generation pattern 60 and the heat resistant temperature of the base 6. It is preferable to perform the preliminary drying until a solvent component included in the heat generation pattern 60 evaporates and dries. In the above preliminary drying, the hot plate is used. In the above preliminary drying, the hot plate is used. Note that a heating apparatus for drying other than the hot plate can be used.

Further, by the second group apparatus 3 as an upstream apparatus of the microwave heating apparatus 10, a solder paste is applied over the electrode portion 55, thereby forming a solder pattern (corresponding to the solder 8) before melting on the electrode portion 55 via the heat generation pattern 60. At this time, the solder pattern before melting is formed to be connected to the electrode portion 55. Next, by the electronic device mounting apparatus, the electronic device 9 (see Figs. 1 and 2) is mounted on the electrode portion 55 via the heat generation pattern 60 and the solder pattern before melting. Note that it is preferable that an ordinary solder resist pattern (not illustrated) is formed by the solder resist forming apparatus before forming the solder pattern.

Next, a single-mode standing wave where a magnetic field and an electric field are separated is formed in the microwave irradiation space 51 of the cylindrical cavity resonator 11 of the third group apparatus 4. In the microwave irradiation space 51 where the standing wave has been formed, the base 6 including the heat generation pattern 60 is caused to pass through the above-described magnetic field region 52 where in effect the electric field does not exist and the magnetic field exists in the magnetic field region 52, and the heat generation pattern 60 is heated. The solder 8 is directly formed on the heat generation pattern 60, and for example, printed by screen printing. Therefore, due to the heat generation by heating the heat generation pattern 60, the heat directly reaches the solder 8 by the heat conduction, thereby heating and melting the solder 8. Then, by stopping the heat generation of the heat generation pattern 60, the solder 8 is cooled and solidified. Consequently, the electrode 91 (see Fig. 2) of the electronic device 9 is joined via the solder 8 solidified on the electrode portion 55, and the electronic device 9 is mounted to the mounting wiring board 50 by the solder 8.

In the soldering and mounting method utilizing the microwave heating method, an induced current and the like is generated in the heat generation pattern 60 under the influence of the magnetic field, and the heat generation pattern 60 is self-heated. On the other hand, because the electric field is hardly formed in the magnetic field region 52, there is no risk that the base 6 is affected due to the influence of the electric field. Accordingly, the occurrence of a spark phenomenon (arc discharge) due to the influence of the electric field on the heat generation pattern 60 and the electrode portion 55 is suppressed. Due to such magnetic field heating, the electronic device 9 is soldered and mounted on the electrode portion 55.

In the above heating method, the heat generation pattern 60 may be heated one or both of by heat generation by an induced current generated in the heat generation pattern 60 due to the magnetic field of the magnetic field region 52, and heat generation by magnetic loss caused by the action of the magnetic field of the magnetic field region 52.

The heating time (microwave irradiation time) of the heat generation pattern 60 in the above heating method is preferably within 600 seconds, more preferably within 30 seconds, further preferably within 10 seconds, from the viewpoint of preventing thermal damage to the base 6. Since the heating time is short as described above, even if the heat generation pattern 60 is heated to a high temperature, thermal damage to the base 6 can be minimized, and the effect that the time required for the soldering and mounting process can be reduced can be obtained. This can also reduce manufacturing costs.

### EXAMPLES

The present invention will be described in more detail based on examples given below, but the invention is not meant to be limited by these.

### [Example 1]

### <Characteristics of magnetic field heating by microwave in heat generation pattern>

A polyethylene terephthalate (PET) sheet was used for the base 6. By a screen printing method using a conductive silver paste (manufactured by Toyochem Co., Ltd., product name REXALPHA), a silver paste pattern to form the electrode portion 55 (55A, 55B) (see Fig. 5(A)) was formed on the base 6. Subsequently, a pre-firing was performed at 60°C for 20 minutes by a hot plate for drying, and a solvent was removed. Thus, a silver electrode portion 55 (1.5 mm × 0.8 mm, thickness 0.03 mm) was formed. Subsequently, on each of the electrode portions 55, by a screen printing method using a nickel paste (manufactured by NIHON HANDA Co., Ltd., product name ECA202), a nickel paste pattern was formed on the electrode portion 55. Then, a pre-firing was performed at 60°C for 20 minutes by the hot plate to dry the nickel paste pattern, and a solvent was removed. Thus, the heat generation pattern 60 (60A, 60B) (0.8 mm × 0.6 mm, thickness 0.03 mm) of nickel (magnetic material) was formed on the upper surface of the electrode portion 55. The proportion of the occupation area of the heat generation pattern 60 relative to the area of the upper surface of the electrode portion 55 in plan view at this time was 40%.

The base surface 6S (see Fig. 1) on which the heat generation pattern 60 of Example 1 was formed was disposed to be positioned on the cylinder central axis C of the cylindrical cavity resonator 11 shown in Fig. 3. A standing wave in TM₁₁₀ mode was formed in the cavity resonator 11, a microwave was radiated with an output of 200 W, and the temperature changes of the electrode portion 55 and the heat generation pattern 60 of Example 1 were observed by an infrared imaging device.

In Example 1, the heat generation pattern 60 (see Fig. 5(A)) of nickel as the magnetic material was irradiated with the microwave with the output of 200 W, and the temperature changes of the electrode portion 55 and the heat generation pattern 60 after 12 seconds were checked. As a result, as shown in Fig. 6, a magnetic loss of the magnetic material caused the temperature inside the heat generation pattern 60 to rapidly rise from 30°C (see Fig. 6(A)) to 150°C (see Fig. 6(B)). Appearances of the heat generation pattern 60, the electrode portion 55, the base 6, and the like were not changed before and after the microwave irradiation. Especially, the rapid temperature change of the heat generation pattern 60 of nickel as the magnetic material was caused by the rapid temperature rise of the nickel heat generation pattern 60 due to the magnetic loss of the magnetic material. From this result, it was found that supporting the heat generation pattern 60 of nickel as the magnetic material allowed selectively controlling a portion to be heated in a short time with a low consumption output and other portions.

### [Comparative Example 1]

The electrode portion 55 (55A, 55B) (see (Fig. 5(B)) (1.5 mm × 0.8 mm, thickness 0.03 mm) was formed on the base 6 by the method similar to Example 1 except that the heat generation pattern was not formed.

The base surface 6S on which the electrode portion 55 of Comparative Example 1 was formed was disposed to be positioned on the cylinder central axis C of the cylindrical cavity resonator 11 shown in Fig. 3. A standing wave in TM₁₁₀ mode was formed in the cavity resonator 11, a microwave was radiated with an output of 200 W, and the temperature change of the electrode portion 55 of Comparative Example 1 was observed by an infrared imaging device.

In Comparative Example 1, the electrode portion 55 (see Fig. 5(B)) of silver as a metal conductor was irradiated with a microwave with an output of 200 W, and the temperature change of the electrode portion 55 after 12 seconds was checked. As a result, an eddy-current loss caused the temperature of the electrode portion 55 to change from 30°C (see Fig. 7(A)) to 84°C (see Fig. 7(B)) after 12 seconds from the irradiation. However, the temperature of the electrode portion 55 did not reach 140°C as the melting point of the solder 8. The appearances of the electrode portion 55 and the base 6 were not changed before and after the microwave irradiation.

### [Example 2]

### <Melting characteristics of solder in magnetic field heating with microwave of heat generation pattern>

Similarly to Example 1, as shown in Fig. 8(A), the electrode portion 55 (55A, 55B) (not illustrated in Fig. 8, see Fig. 2) was formed on a PET sheet as the base 6, and the heat generation pattern 60 (60A, 60B) was formed on the upper surface of the electrode portion 55 (55A, 55B). On each of the electrode portions 55, a solder paste pattern 8 (8A, 8B) (manufactured by Senju Metal Industry Co., Ltd., product name Eco Solder Paste LT142) was formed by applying via the heat generation pattern 60.

Then, the base 6 on which the solder paste pattern 8 was formed was disposed on a polyimide sheet disposed to pass through the central axis of the cylindrical cavity resonator 11. A standing wave in TM₁₁₀ mode was formed in the cavity resonator 11, and a microwave was radiated with an output of 200 W for 5 seconds. Then, the temperature changes of the solder 8 and the like were checked by measuring the temperatures with images taken by an infrared temperature monitor (not illustrated) from the solder 8 side.

As a result, in Example 2, it was confirmed that the temperature of the solder paste rose from 26°C before the microwave irradiation to 150°C after the irradiation. Then, the base 6 was taken out from the cavity resonator 11, and the appearance of the PET substrate of the base 6 was observed. As a result, it was confirmed that the solder 8 was melted (shining portion) and the PET base 6 was not deformed (see Fig. 8(B)).

### [Comparative Example 2]

Similarly to Comparative Example 1, as shown in Fig. 9(A), the electrode portion 55 (55A, 55B) was formed on a PET sheet as the base 6. On each of the electrode portions 55, a solder paste pattern 8 (8A, 8B) (manufactured by Senju Metal Industry Co., Ltd., product name Eco Solder Paste LT142) was formed by applying.

Then, the base 6 on which the solder paste pattern 8 was formed was disposed on a polyimide sheet disposed to pass through the central axis of the cylindrical cavity resonator 11. A standing wave in TM₁₁₀ mode was formed in the cavity resonator 11, and a microwave was radiated with an output of 200 W for 60 seconds. Then, the temperature changes of the electrode portion and the like were checked by measuring the temperatures with images taken by an infrared temperature monitor (not illustrated) from the solder paste pattern 8 side.

As a result, in Comparative Example 2, it was confirmed that the temperature of the solder paste rose from 26.8°C before the microwave irradiation to 128.6°C after the irradiation. Then, the base 6 was taken out from the cavity resonator 11, and the appearance of the PET substrate 6 of the base 6 was observed. As a result, it was confirmed that the solder 8 was not melted and the PET base 6 was not deformed (see Fig. 9(B)).

### [Example 3]

### <Mounting example of electronic device using heat generation pattern>

Similarly to Example 1, as shown in Fig. 10(A), the electrode portion 55 (55A, 55B) was formed on a PET sheet as the base 6, and the heat generation pattern 60 (60A, 60B) (not illustrated in Fig. 10, see Fig. 2) was formed on the upper surface of the electrode portion 55 (55A, 55B). On each of the electrode portions 55, a solder paste pattern 8 (8A, 8B) (manufactured by Senju Metal Industry Co., Ltd., product name Eco Solder Paste LT142) was formed by applying via the heat generation pattern 60. Further, a capacitor was mounted as the electronic device 9 on the solder paste pattern 8. At this time, the capacitor was connected to couple between the solder paste patterns 8A and 8B.

Then, the base 6 on which the electronic device 9 was mounted was disposed on a polyimide sheet disposed to pass through the central axis of the cylindrical cavity resonator 11. A standing wave in TM₁₁₀ mode was formed in the cavity resonator 11, and a microwave was radiated with an output of 200 W for 25 seconds. Then, the temperature changes of the electrode portion and the like were checked by measuring the temperatures with images taken by an infrared temperature monitor (not illustrated) from the electrode portion 9 side.

As a result, in Example 3, it was confirmed that the temperature of the solder paste rose from a state before the microwave irradiation (28°C) (see Fig. 10(C)) to 150°C that was equal to or more than 140°C as the melting temperature of the solder 8 (see Fig. 10(D)). Then, the base 6 was taken out from the cavity resonator 11, and the appearance of the PET substrate of the base 6 was observed. As a result, it was confirmed that the solder 8 was melted (shining portion of the solder 8 in Fig. 10(B) and the PET base 6 was not deformed (see Fig. 10(B)).

### [Comparative Example 3]

Similarly to Comparative Example 1, as shown in Fig. 11(A), the electrode portion 55 (55A, 55B) was formed on a PET sheet as the base 6. On each of the electrode portions 55, a solder paste pattern 8 (8A, 8B) (manufactured by Senju Metal Industry Co., Ltd., product name Eco Solder Paste LT142) was formed by applying. Further, a capacitor was mounted as the electronic device 9 on the solder paste pattern 8. At this time, the capacitor was connected to couple between the solder paste patterns 8A and 8B.

Then, the base 6 on which the electronic device 9 was mounted was disposed on a polyimide sheet disposed to pass through the central axis of the cylindrical cavity resonator 11. A standing wave in TM₁₁₀ mode was formed in the cavity resonator 11, and a microwave was radiated with an output of 50 W for 70 seconds. Then, the temperature changes of the electrode portion and the like were checked by measuring the temperatures with images taken by an infrared temperature monitor (not illustrated) from the electronic device 9 side.

As a result, in Comparative Example 3, it is confirmed that the solder paste did not reach 140°C, which is the melting temperature of the solder 8, from the state before the microwave irradiation (28°C) (see Fig. 11 (C)), and rose to 124°C (see Fig. 11 (D)). Then, the base 6 was taken out from the cavity resonator 11, and the appearance of the PET substrate 6 of the base 6 was observed. As a result, it was confirmed that the solder 8 was not melted and the PET base 6 was not deformed (see Fig. 11(B)).

From the above-described results, it is clear that the heat generation pattern 60 in the present invention supports the efficient solder melting process using the microwave, and allows mounting the electronic device 9.

### DESCRIPTION OF SYMBOLS

1 Soldering and mounting apparatus
2 First group apparatus
3 Second group apparatus
4 Third group apparatus (microwave heating apparatus 10)
6 Base
8 Object to be heated (solder)
9 Electronic device
10 Microwave heating apparatus
11 Cavity resonator
12 Inlet
13 Outlet
14 Microwave supply port
15 Window
21 Microwave generator
22 Microwave amplifier
23 Isolator
24 Matcher
25 Antenna
26, 42, 45, 46, 47 Cable
31 Transfer mechanism
31A Supply-side transfer unit
31B Sending-side transfer unit
41 Thermal image measurement apparatus
43 Control unit
44 Electromagnetic wave sensor
50 Mounting wiring board
55 Electrode portion
60 Heat generation pattern
C Cavity central axis (central axis)

## Claims

1. A mounting wiring board (50), comprising:
a base (6);
an electrode portion (55) disposed on the base (6); and
a heat generation pattern (60) disposed on the electrode portion (55) and heatable by a magnetic field of a standing wave of a microwave;
wherein the material of the heat generation pattern (60) includes a ferromagnet selected from iron, cobalt, nickel or an alloy of them, and a ferrite, or, a non-magnetic metal conductor, and the heat generation pattern (60) is formed of a thin film, a collective body of a powder, or a liquid;
wherein an occupation area of the heat generation pattern (60) is smaller than an area of an upper surface of the electrode portion (55);
wherein solder (8) meltable by a heat generation of the heat generation pattern-is-disposed on the electrode portion (55) to be electrically connected to the electrode portion (55) at least via the heat generation pattern (60), and
wherein an occupation area of the heat generation pattern (60) is smaller than an area of a lower surface of the solder (8).

2. A method of mounting an electronic device (9), comprising the steps of:
heating the heat generation pattern (60) of the mounting wiring board (50) according to Claim 1 by a magnetic field of a standing wave formed by a microwave irradiation to melt the solder (8) disposed on the heat generation pattern (60), and
subsequently solidifying the solder to electrically connect an electrode (91) of the electronic device to the electrode portion (55) via the solder (8).

3. The method of mounting an electronic device according to Claim 2, wherein the standing wave is TMₙ₁₀ , where an is an integer of 1 or more, mode or TE₁₀ₙ, where n is an integer of 1 or more, mode.

4. The method of mounting an electronic device according to any one of Claim 2 or 3, comprising the steps of:
transferring the mounting wiring board according to Claim 1 in a cylindrical cavity resonator (11); and
forming the standing wave in the cylindrical cavity resonator (11) by radiating a microwave so as to have a magnetic field strength uniform and maximum along a cylinder central axis (C) and melting the solder by the heat generation pattern (60) heated by an action of the magnetic field.

5. The method of mounting an electronic device according to Claim 4, wherein the frequency of the microwave supplied to the cavity resonator (11) is adjusted corresponding to the change of the resonance frequency of the standing wave formed in the cavity resonator (11) to maintain the formation state of the standing wave in the cavity resonator (11).

6. A mounting wiring board (50) having an electronic device (9) attached thereon, comprising:
a base (6);
an electrode portion (55) disposed on the base;
a heat generation pattern (60) disposed on the electrode portion (55) and heatable by a magnetic field of a standing wave of a microwave;
solder (8) disposed on the electrode portion (55) to be electrically connected to the electrode portion (55) at least via the heat generation pattern (60); and
an electronic device (9) including an electrode (91) disposed on the solder (8),
wherein an occupation area of the heat generation pattern (60) is smaller than an area of an upper surface of the electrode portion (55);
wherein an occupation area of the heat generation pattern (60) is smaller than an area of a lower surface of the solder (8); and
wherein the material of the heat generation pattern (60) includes a ferromagnet selected from iron, cobalt, nickel or an alloy of them, and a ferrite, or, a non-magnetic metal conductor, and the heat generation pattern (60) is formed of a thin film, a collective body of a powder, or a liquid.

## Patentansprüche

1. Montage-Leiterplatte (50), umfassend:
eine Basis (6);
einen auf der Basis (6) angeordneten Elektrodenabschnitt (55); und
ein Wärmeentwicklungsmuster (60), das auf dem Elektrodenabschnitt (55) angeordnet ist und durch ein Magnetfeld einer stehenden Welle einer Mikrowelle erwärmt werden kann;
wobei das Material des Wärmeerzeugungsmusters (60) einen Ferromagneten, ausgewählt aus Eisen, Kobalt, Nickel oder einer Legierung davon, und ein Ferrit oder einen nichtmagnetischen Metallleiter umfasst, und das Wärmeerzeugungsmuster (60) aus einer dünnen Schicht, einem kollektiven Körper von Pulver oder einer Flüssigkeit gebildet ist;
wobei eine Belegungsfläche des Wärmeerzeugungsmusters (60) kleiner ist als eine Fläche einer Oberseite des Elektrodenabschnitts (55);
wobei Lötmittel (8), das durch die Wärmeerzeugung des Wärmeerzeugungsmusters schmelzbar ist, auf dem Elektrodenabschnitt (55) angeordnet ist, um zumindest über das Wärmeerzeugungsmuster (60) elektrisch mit dem Elektrodenabschnitt (55) verbunden zu sein, und
wobei eine Belegungsfläche des Wärmeerzeugungsmusters (60) kleiner ist als eine Fläche einer Unterseite des Lötmittels (8).

2. Verfahren zur Montage einer elektronischen Vorrichtung (9), das die folgenden Schritte umfasst:
Erwärmen des Wärmeerzeugungsmusters (60) der Montage-Leiterplatte (50) nach Anspruch 1 durch ein Magnetfeld einer durch Mikrowellenstrahlung gebildeten stehenden Welle, um das auf dem Wärmeerzeugungsmuster (60) angeordnete Lötmittel (8) zu schmelzen, und
anschließendes Erstarrenlassen des Lötmittels, um eine Elektrode (91) der elektronischen Vorrichtung über das Lötmittel (8) elektrisch mit dem Elektrodenabschnitt (55) zu verbinden.

3. Verfahren zum Montieren einer elektronischen Vorrichtung gemäß Anspruch 2, wobei die stehende Welle ein TMₙ₁₀ Modus ist, wobei n eine ganze Zahl von 1 oder mehr ist, oder ein TE₁₀ₙ Modus ist, wobei n eine ganze Zahl von 1 oder mehr ist.

4. Verfahren zum Montieren einer elektronischen Vorrichtung gemäß einem der Ansprüche 2 oder 3, das die folgenden Schritte umfasst:
Überführen der Montage-Leiterplatte gemäß Anspruch 1 in einen zylindrischen Hohlraumresonator (11); und
Bilden der stehenden Welle in dem zylindrischen Hohlraumresonator (11) durch Strahlung mit einer Mikrowelle, so dass eine gleichmäßige und maximale Magnetfeldstärke entlang einer Zylindermittelachse (C) entsteht, und Schmelzen des Lötmittels durch das durch die Einwirkung des Magnetfelds erhitzte Wärmeerzeugungsmuster (60).

5. Verfahren zum Montieren einer elektronischen Vorrichtung nach Anspruch 4, wobei die Frequenz der dem Hohlraumresonator (11) zugeführten Mikrowelle entsprechend der Änderung der Resonanzfrequenz der im Hohlraumresonator (11) gebildeten stehenden Welle eingestellt wird, um den Bildungszustand der stehenden Welle im Hohlraumresonator (11) aufrechtzuerhalten.

6. Montage-Leiterplatte (50) mit einer darauf befestigten elektronischen Vorrichtung (9), umfassend:
eine Basis (6);
einen auf der Basis angeordneten Elektrodenabschnitt (55);
ein Wärmeerzeugungsmuster (60), das auf dem Elektrodenabschnitt (55) angeordnet ist und durch ein Magnetfeld einer stehenden Welle einer Mikrowelle erwärmt werden kann;
Lötmittel (8), das auf dem Elektrodenabschnitt (55) angeordnet ist, um zumindest über das Wärmeerzeugungsmuster (60) elektrisch mit dem Elektrodenabschnitt (55) verbunden zu sein; und
eine elektronische Vorrichtung (9) mit einer Elektrode (91), die auf dem Lötmittel (8) angeordnet ist,
wobei eine Belegungsfläche des Wärmeerzeugungsmusters (60) kleiner ist als eine Fläche einer Oberseite des Elektrodenabschnitts (55);
wobei eine Belegungsfläche des Wärmeerzeugungsmusters (60) kleiner ist als eine Fläche einer Unterseite des Lötmittels (8); und
wobei das Material des Wärmeerzeugungsmusters (60) einen Ferromagneten, ausgewählt aus Eisen, Kobalt, Nickel oder einer Legierung davon, und ein Ferrit oder einen nichtmagnetischen Metallleiter umfasst, und das Wärmeerzeugungsmuster (60) aus einer dünnen Schicht, einem kollektiven Körper von Pulver oder einer Flüssigkeit gebildet wird.

## Revendications

1. Carte de câblage de montage (50), comprenant:
une base (6);
une partie d'électrode (55) disposée sur la base (6); et
un motif de génération de chaleur (60) disposé sur la partie d'électrode (55) et pouvant être chauffé par un champ magnétique d'une onde stationnaire d'une micro-onde;
dans laquelle le matériau du motif générateur de chaleur (60) comprend un ferromagnétique choisi parmi le fer, le cobalt, le nickel ou un alliage de ceux-ci, et une ferrite, ou un conducteur métallique non magnétique, et le motif générateur de chaleur (60) est formé d'un film mince, d'un corps collectif de poudre ou d'un liquide;
dans lequel une zone d'occupation du motif de génération de chaleur (60) est plus petite qu'une zone d'une surface supérieure de la partie d'électrode (55);
dans lequel une soudure (8) pouvant fondre sous l'effet de la génération de chaleur du motif de génération de chaleur est disposée sur la partie d'électrode (55) afin d'être connectée électriquement à la partie d'électrode (55) au moins via le motif de génération de chaleur (60), et
dans lequel une zone d'occupation du motif de génération de chaleur (60) est plus petite qu'une zone d'une surface inférieure de la soudure (8).

2. Procédé de montage d'un dispositif électronique (9), comprenant les étapes suivantes:
chauffer le motif de génération de chaleur (60) de la carte de câblage de montage (50) selon la revendication 1 à l'aide d'un champ magnétique d'une onde stationnaire formée par un rayonnement micro-ondes afin de faire fondre la soudure (8) disposée sur le motif de génération de chaleur (60), et
solidifier ensuite la soudure pour connecter électriquement une électrode (91) du dispositif électronique à la partie d'électrode (55) via la soudure (8).

3. Procédé de montage d'un dispositif électronique selon la revendication 2, dans lequel l'onde stationnaire est de mode TMₙ₁₀, où n est un nombre entier supérieur ou égal à 1, ou de mode TE₁₀ₙ, où n est un nombre entier supérieur ou égal à 1.

4. Procédé de montage d'un dispositif électronique selon l'une des revendications 2 ou 3, comprenant les étapes suivantes:
transférer la carte de câblage de montage selon la revendication 1 dans un résonateur à cavité cylindrique (11); et
former l'onde stationnaire dans le résonateur à cavité cylindrique (11) en rayonnant une micro-onde de manière à obtenir une intensité de champ magnétique uniforme et maximale le long d'un axe central cylindrique (C) et faire fondre la soudure par le motif de génération de chaleur (60) chauffé par l'action du champ magnétique.

5. Procédé de montage d'un dispositif électronique selon la revendication 4, dans lequel la fréquence des micro-ondes fournies au résonateur à cavité (11) est ajustée en fonction du changement de la fréquence de résonance de l'onde stationnaire formée dans le résonateur à cavité (11) afin de maintenir l'état de formation de l'onde stationnaire dans le résonateur à cavité (11).

6. Carte de câblage de montage (50) sur laquelle est fixé un dispositif électronique (9), comprenant:
une base (6);
une partie d'électrode (55) disposée sur la base;
un motif de génération de chaleur (60) disposé sur la partie d'électrode (55) et pouvant être chauffé par un champ magnétique d'une onde stationnaire d'une micro-onde;
une soudure (8) disposée sur la partie d'électrode (55) afin d'être connectée de manière électriquement à la partie d'électrode (55) au moins via le motif de génération de chaleur (60); et
un dispositif électronique (9) comprenant une électrode (91) disposée sur la soudure (8),
dans lequel une zone d'occupation du motif de génération de chaleur (60) est plus petite qu'une zone d'une surface supérieure de la partie d'électrode (55);
dans lequel une zone d'occupation du motif de génération de chaleur (60) est plus petite qu'une zone d'une surface inférieure de la soudure (8); et
dans lequel le matériau du motif de génération de chaleur (60) comprend un ferromagnétique choisi parmi le fer, le cobalt, le nickel ou un alliage de ceux-ci, et
une ferrite, ou un conducteur métallique non magnétique, et le motif de génération de chaleur (60) est formé d'un film mince, d'un corps collectif de poudre ou d'un liquide.
